## Europäisches Patentamt

## European Patent Office

## Office européen des brevets

(11) Publication number: **0 074 845**
**B1**

(12) **EUROPEAN PATENT SPECIFICATION**

(45) Date of publication of patent specification: **11.01.89**

(51) Int. Cl.⁴: **H 01 L 21/32, C 09 K 13/02**

(21) Application number: **82304831.9**

(22) Date of filing: **14.09.82**

(54) **Etching polyimide resin layers and method of manufacturing a semiconductor device having a layer of polyimide resin.**

(30) Priority: **14.09.81 JP 145320/81**

(43) Date of publication of application:
**23.03.83 Bulletin 83/12**

(45) Publication of the grant of the patent:
**11.01.89 Bulletin 89/02**

(84) Designated Contracting States:
**DE FR GB**

(56) References cited:
**US-A-4 068 018**
**US-A-4 158 141**
**US-A-4 394 211**

**SOLID-STATE TECHNOLOGY, August 1981, pages 60-67, Murray Hill, New Jersey, US; W.L. BROWN et al.: "Ion beam lithography"**

**JAPANESE JOURNAL OF APPLIED PHYSICS, vol. 19, no. 10, October 1980, pages L615-L617, Tokyo, JP; H. KUWANO et al.: "Dry development of resists exposed to focused gallium ion beam"**

(73) Proprietor: **FUJITSU LIMITED**
**1015, Kamikodanaka Nakahara-ku**
**Kawasaki-shi Kanagawa 211 (JP)**

(72) Inventor: **Uchiyama, Nobuhiro c/o FUJITSU LIMITED**
**Patent Department 1015 Kamikodanaka Nakahara-ku**
**Kawasaki-shi Kanagawa 211 (JP)**
Inventor: **Shingu, Masataka c/o FUJITSU LIMITED**
**Patent Department 1015 Kamikodanaka Nakahara-ku**
**Kawasaki-shi Kanagawa 211 (JP)**
Inventor: **Tsukada, Saburo c/o FUJITSU LIMITED**
**Patent Department 1015 Kamikodanaka Nakahara-ku**
**Kawasaki-shi Kanagawa 211 (JP)**

(74) Representative: **Sunderland, James Harry et al**
**HASELTINE LAKE & CO Hazlitt House 28 Southampton Buildings Chancery Lane London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## EP 0 074 845 B1

(58) References cited:
**Idem
PATENTS ABSTRACTS OF JAPAN, vol. 5, no.
192 (E-85)864r, 8th December 1981; & JP - A -
56 115 537 (OKI DENKI KOGYO K.K.) 10-09-1981**

**Description**

This invention relates to etching polyimide resin layers and a method of manufacturing a semiconductor device having a layer of polyimide resin.

Thermosetting polyimide resin is a material which can be used for forming an insulating layer in a semiconductor device having a multilayer wiring structure. The application of such polyimide resin material in a semiconductor device is disclosed in U.S. Patent No. 3,700,497. In its application in a semiconductor device, it is the heat resistivity of polyimide resin that is excellent as compared with that of other organic thermosetting resins. Further, polyimide resin can be etched with excellent reproduceability, particularly by an etching solution of the hydrazine system, and allows the formation of fine patterns. This is a very important advantage for the application of polyimide resin material in a semiconductor device. An etching technique using etching solution of the hydrazine system is disclosed in U.S. Patent No. 4,218,283. In addition to ordinary polyimide resin obtained by the condensation reaction of polyamic acid, polyimide - iso - indoloquinazolinedione (PIQ) as described in U.S. Patent No. 4,218,283 is also referred to in this specification as polyimide resin.

When polyimide resin is used as an interlayer insulator in a multilayer wiring structure, it is often required repeatedly to form polyimide resin layers and to pattern the layers by selective etchings. In such a case, it is desirable that a previously formed polyimide layer pattern be insoluble with regard to the etching solution used in a succeeding etching process for forming a further polyimide layer pattern. It is known of course, that the etching rate of polymide can be changed by adjusting the composition of etching solution.

US—A—4 068 018 discloses the implantation of ions, such as $^{31}P^+$, $^{11}B^+$, $^{20}Ne^+$, $^{40}Ar^-$, $^{49}BF_2$, $^{70}B_2O_3{}^+$, accelerated to a high energy level, preferably over 50 KeV, to a dose level preferably over $10^{14}/cm^2$, into an organic film, having a thickness of 30 nm (300 Å) to 10 µm, of material selected from:— known photo-resists, polymethyl acrylate, rubber, novolak, polyethylene, polystyrene and polyimide, or a combination thereof. This ion implanation is to harden or carbonize the film so that it shields ultraviolet and/or visible light and presents strong resistance to acid such as hydrochloric acid, sulphuric acid, hydrofluoric acid, aqua regia or the like.

A film of photoresist AZ-1350 of a thickness of about 400 nm (4000 Å) implanted with $^{31}P^+$ ions to a dose level of $10^{16}/cm^2$ can offer improved resistance to chemicals such as hot sulphuric acid, hot nitric acid, photoresist removing agent (such as OMR removing agent made by Tokyo Oka Kogyo Co.). So, the implanted film can be repeatedly cleaned using a cleaning chemical.

Solid State Technology, August 1981, pages 60 to 67, "Ion Beam Lithography", states that "virtually any polymer and many organic materials can be used as negative resists by implanting low energy ions such that upon subsequent relative ion etching of the resist layer, in a suitable plasma, the implanted ions form nonvolatile compounds which act as an in situ mask. The unimplanted regions are etched away". Use as resist materials, for active ion etching, of inorganic $SiO_2$ film and of thick organic polymers is mentioned, as is a poly - (vinylcarbazole) - trinitrofluorinone complex and as are resists of the germanium selenide/silver selenide system.

Patent Abstracts of Japan, Vol. 5, No. 192 (E85) (864), referring to Japanese Patent Application No. 56-115537, mentions irradiating a resist film with a plasma or ion beam, then allowing it it stand in $O_2$ plasma. Unirradiated parts are removed.

US—A—4 068 018 is thus concerned with light transmissivity and resistance to strong acids, whilst the Solid State Technology and Patent Abstracts of Japan disclosures are concerned with reactive ion or plasma etching.

According to the present invention there is provided a method of manufacturing a semiconductor device having a multilayer wiring structure, comprising the steps of:—

forming a first-level wiring layer on a substrate,

forming a first polyimide resin layer on the substrate with at least part of the first-level wiring layer exposed through the first polyimide resin layer,

implanting ions into the first polyimide resin layer, to substantially decrease its susceptibility to etching by an etchant containing hydrazine,

forming a second polymide resin layer on the ion-implanted first polyimide resin layer and the first-level wiring layer,

selectively etching the second polyimide resin layer using an etchant containing hydrazine, to form a through-hole in that layer as a wiring connection window in which a part of the first-level wiring layer is exposed, and

forming on the second polyimide resin layer, a second-level wiring layer, connected to the first-level wiring layer through the wiring connection window,

whereby if part of the first polyimide resin layer is exposed in the through-hole, it remains substantially unetched, as a result of its decreased susceptibility to etching.

It has been determined, by the inventors of the present invention, that the susceptibility of a polyimide resin layer to etching by an etchant containing hydrazine can be modified by implanting ions into the layer.

The present invention thus involves use of the phenomenon of selectable reduction of the etching rate of a polyimide resin layer with regard to an etching solution containing hydrazine.

In embodiments of the present invention there is no particular limitation on the species of ion which may be implanted, but it is convenient to use impurity ions such as arsenic ions, phosphorus ions and boron ions because they are in general use in the manufacture of semiconductor devices. Implantation energy can also be determined freely to a value larger than the lower limit causing sputtering, namely to a value almost equal to 10 KeV or more. In order to cause a substantial change of etching rate, it is necessary to implant the ions with a dosage of $1 \times 10^{13}$ cm$^{-2}$ or more, desirably $1 \times 10^{14}$ cm$^{-2}$. As to the polyimide resin of which the etching rate is controlled by such ion implantation, there is no particular limitation on the kind of polyimide resin, and any kind of polyimide resin including PIQ disclosed in the above mentioned prior art reference can be used.

The etching rate of a polyimide resin layer having suffered ion implantation can be reduced to such a degree as to make the layer substantially completely resistant to an etching solution of the hydrazine system. The ion implantation can be selectively carried out for a desired region of a polyimide resin layer, depending on the structure of semiconductor device to be manufactured. When a plurality of levels of polyimide resin layer patterns are to be formed on a substrate, the process of forming an upper polyimide resin pattern should take place after the execution of ion implantation into the surface of a lower polyimide resin pattern. In some cases, the execution of local ion implantation using an adequate masking layer such as a resist layer on a single level polyimide resin layer may be useful, depending on the device structure.

Reference is made, by way of example, to the accompanying drawings, in which:—

Figure 1 is a graph illustrating the relationship between ion implantation dose and resultant etching rate of polyimide resin, and

Figures 2A to Figure 2G are schematic sectional views illustrating a process for manufacturing a semiconductor device having a multilayer wiring structure in accordance with an embodiment of the present invention.

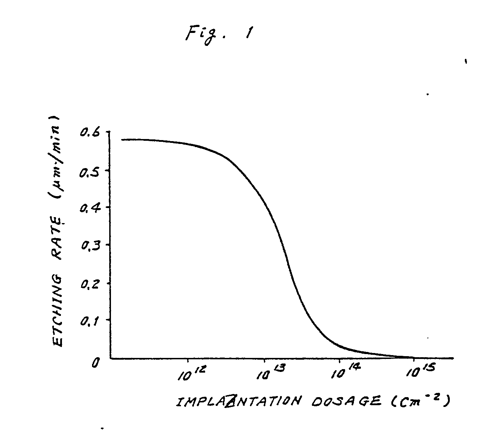

Figure 1 is a graph illustrating the etching rate of ion implanted polyimide resin layer. The graph of Figure 1 is plotted from information obtained by following the procedures described below for polyimide resin layers subjected to various ion implantation doses. The polyimide resin used in each case was synthesized through a curing process using a polyimide prepolymer consisting of polyamic acid marketed by the trade name of SP 760 from Toray Kabushishiki Kaisha. A prepolymer solution having a concentration of nonvolatile component of 14.6% was coated on a silicon substrate, preliminary curing was carried out at a temperature of 150°C and 200°C in air, thereafter further curing was carried out for 30 minutes at a temperature of 450°C in a nitrogen ambient and thereby the coated layer was converted into a polyimide resin layer. Then, boron difluoride ions (BF$_2$$^+$) were implanted onto the polyimide resin layer. The implantation energy was 100 KeV. Various dose amounts were employed as shown on the horizontal axis in Figure 1. The etchant used in each case was composed of 16 wt.% ethylenediamine (98% aqueous solution) and the rest hydrazine hydrate (98% aqueous solution). This solution was kept at 35°C and etching of the ion implanted polyimide resin layer was carried out. The results are shown in the graph of Figure 1. As will be clear from this graph, when dosage exceeds $1 \times 10^{13}$ cm$^{-12}$, the etching rate of polyimide resin is substantially reduced and when ion implantation is carried out with a dosage of $1 \times 10^{14}$ cm$^{-2}$, the resultant polyimide resin is very nearly not etched at all.

In other cases ion implantation was carried out using ion species other than BF$_2$$^+$, as indicated in Table 1, which also indicates change of the etching rate for different dose amounts. The polyimide resin used in each case, and etching conditions in each case, were the same as those selected for the experiments upon which the graph of Figure 1 is based.

TABLE 1

| Ion species | Acceleration energy | Dosage | Etching rate |
|---|---|---|---|
| Arsenic (As$^+$) | 180 KeV | $1 \times 10^{14}$ atm/cm$^2$<br>$1 \times 10^{15}$ atm/cm$^2$ | 0.02 μm/min<br>to 0 μm/min |
| Phosphorus (P$^+$) | 80 KeV | $1 \times 10^{14}$ atm/cm$^2$<br>$1 \times 10^{15}$ atm/cm$^2$ | 0.05 μm/min<br>to 0 μm/min |
| Boron (B$^+$) | 25 KeV | $1 \times 10^{14}$ atm/cm$^2$<br>$1 \times 10^{15}$ atm/cm$^2$ | 0.3 μm/min<br>to 0 μm/min |

From Table 1, it is clear that the same result as illustrated in Figure 1, can be obtained even when the ion species or the ion implantation energy is changed. Namely, etching rate is largely changed (reduced) at a dosage of $1 \times 10^{14}$ cm$^{-2}$ and moreover etching is substantially prevented in polyimide resin implanted with ions with a dose amount of $10^{15}$ cm$^{-2}$ or more. Here, it should be noted that the important characteristics of polyimide resin for application in a semiconductor device, such as heat resistivity and electrical insulating properties, do not suffer any substantially deterioration at a dosage of about $1 \times 10^{15}$ cm$^{-2}$. Therefore, the above method for controlling the etching rate of polyimide resin layer by ion implantation can be adapted for manufacture of a semiconductor device.

4

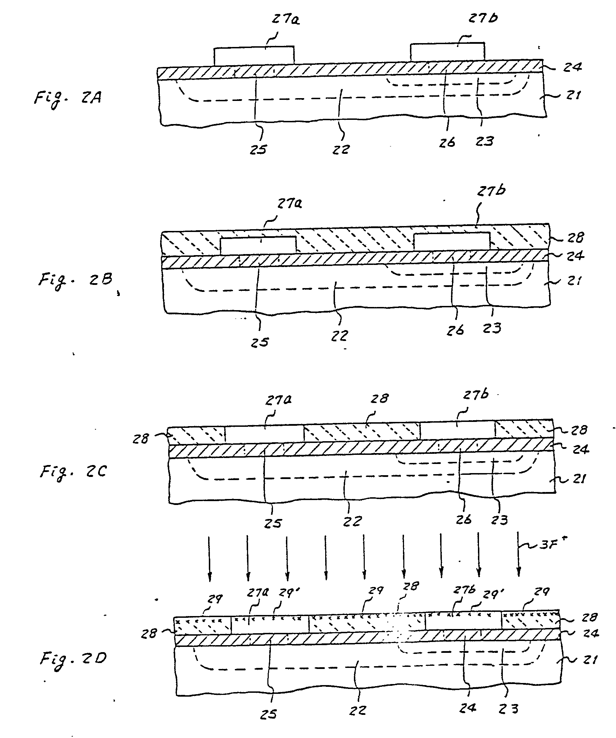

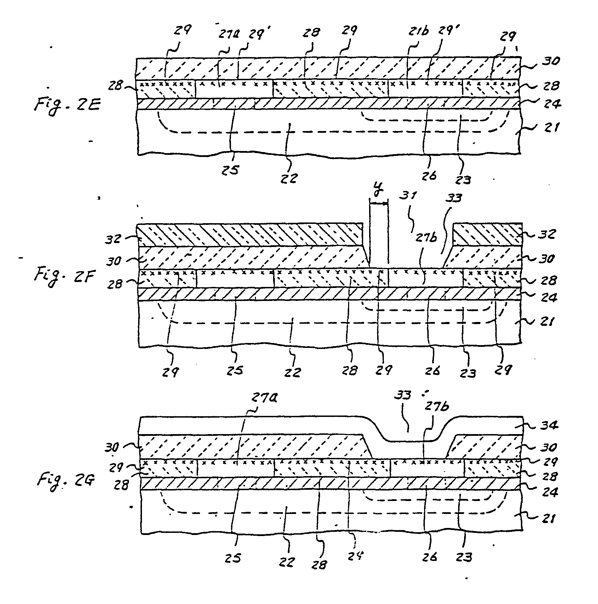

For example, the manufacture of a bipolar type semiconductor device having a multilayer wiring structure by a process embodying the present invention is explained hereinbelow with reference to Figure 2.

First, as shown in Figure 2A, a substrate is prepared by the following steps:— a base diffusion region 22 and an emitter diffusion region 23 etc. are formed, using ordinary processes, on the semiconductor substrate, for example in a silicon epitaxial layer 21, whilst a lower $SiO_2$ insulating film 24 is formed on the silicon epitaxial layer 21, and moreover electrode windows 25 and 26, etc. for the base diffusion region 22 and the emitter diffusion region 23, are formed on the lower $SiO_2$ insulating film 24, and lower Al wirings 27a, 27b etc., which are connected respectively to the base diffusion region 22 and emitter diffusion region 23 etc., in the electrode windows 25 and 26, are formed on the lower $SiO_2$ insulating film 24.

Thereafter, as shown in Figure 2B, a first polyimide layer 28 is formed on the substrate of Figure 2A by spin coating polyamic acid solution and by a step curing process. The layer 28 is of such a thickness as to perfectly embed therein the lower Al wirings 27a and 27b etc.

Desirable conditions for the use of the polyamic acid SP 760 (trade name of a product supplied by Toray Kabushiki Kaisha) as employed in the experiments upon which Figure 1 is based, are as follows.

With adjustment of viscosity of the polyamic acid solution to 700 cp, spin coating is carried out by rotating the substrate at 4000 rpm. For curing the coated solution, a step curing is carried out with three steps each of 30 minutes and at 150°C, 200°C and 450°C respectively. The polyimide layer formed has a thickness of 1.3 µm.

Thereafter, as shown in Figure 2C, the first polyimide layer 28 is evenly removed from the surface until the upper surface of the lower Al wirings 27a, 27b is perfectly exposed. This is effected for example by ordinary oxygen ($O_2$) plasma processing.

At this time, any dent part or indentation having been formed between the lower wirings 27a, 27b is filled in by the first polyimide layer 28.

The boron difluoride ions ($BF_2^+$) with a dosage of $1 \times 10^{15}$ cm$^{-2}$ or so are implanted, for example with an acceleration energy of about 100 KeV, into the surface of the substrate to be processed and, as shown in Figure 2D, a high concentration implantation region 29 of $BF_2^+$ is formed on the surface of the first polyimide layer 28. In this case, a very shallow $BF_2^+$ implanted region 29' is also formed at the upper surface of the lower Al wirings 27a, 27b, but it does not cause deterioration of the quality of the wiring surfaces.

Next, as shown in Figure 2E, a second polyimide layer 30 is formed, to a thickness of about 1 µm, on the first polyimide layer 28 and upper surfaces of lower Al wirings 27a, 27b etc. through a step curing process similar to that mentioned above using the same material as that of the first polyimide layer 28 and by executing spin coating at 4500 rpm.

Thereafter, as shown in Figure 2F, a negative resist film 32 of the rubber system having an etching window 31 (for example for forming a wiring connection window giving access to a desired surface region of the lower wiring 27b) is formed by an ordinary photo process on the second polyimide layer 30.

Then, with the photo resist film 32 used as a mask, selective etching is carried out for the second polyimide layer 30 by an ordinary wet etching method using a polyimide etching solution consisting of hydrazine solution or a mixed solution of hydrazine and ethylenediamine and thereby the wiring connection window (through hole) 33 is formed in the layer 30 in which window the upper surface of the lower Al wiring 27b is exposed. In this case, as shown in the Figure, even if some misalignment occurs between the wiring connection window 33 and the lower Al wiring 27b, no indentations are formed in the displaced (exposed) polyimide resin (see 'y') as a result of over-etching because the high $BF_2^+$ concentration of the region 29 formed at the upper surface of the first polyimide layer 28 gives a very high resistivity to etching to expose the region y.

Thereafter, as shown in Figure 2G, upper wiring, for example an upper Al wiring 34, which comes into contact with the lower Al wiring 27b at the wiring connection window 33, is formed on the second polyimide layer 30 by an ordinary method such as vacuum evaporation or sputtering and selective etching etc.

In a method embodying the present invention, no step is formed between the first polyimide layer 28 exposed within the wiring connection window 33 and the upper surface of the lower Al wiring 27b as a result of misalignment between the wiring connection window 33 and the lower Al wiring 27b. Therefore defects such as cracks do not occur at the upper Al wiring 34 in the wiring connection window 33.

According to the present invention, in order to selectively reduce the etching rate of a polyimide resin layer, ion implantation into the layer is carried out. Preferably, impurity ions such as $As^+$, $P^+$, $B^+$, $BF_2^+$ are implanted with a dosage of $1 \times 10^{14}$ cm$^{-2}$ or more. As a result, the polyimide resin layer has a resistivity to etching by an etchant containing hydrazine. This method can be used for preventing occurrence of unwanted etching in the process of forming a through hole when using polyimide resin as an interlayer insulator for a multilayer wiring structure.

## Claims

1. A method of manufacturing a semiconductor device having a multilayer wiring structure, comprising the steps of:—

forming a first-level wiring layer (27a, 27b) on a substrate (21, 24),

forming a first polyimide resin layer (28) on the substrate (21, 24) with at least part of the first-level wiring layer (27a, 27b) exposed through the first polyimide resin layer,

implanting ions into the first polyimide resin layer (28), to substantially decrease its susceptibility to etching by an etchant containing hydrazine,

forming a second polyimide resin layer (30) on the ion-implanted first polyimide resin layer (28) and the first-level wiring layer (27a, 27b),

selectively etching the second polyimide resin layer (30) using an etchant containing hydrazine, to form a through-hole (33) in that layer as a wiring connection window in which a part of the first-level wiring layer (27a, 27b) is exposed, and

forming on the second polyimide resin layer (30) a second-level wiring layer (34), connected to the first-level wiring layer (27a, 27b) through the wiring connection window (33),

whereby if part of the first polyimide resin layer (28) is exposed in the through-hole (33), it remains substantially unetched, as a result of its decreased susceptibility to etching.

2. A method as claimed in claim 1, wherein the first polyimide resin layer (28) is formed by a process which comprises the steps of: forming a polyimide resin coating over the first-level wiring layer (27a, 27b) on the substrate (21, 24), and removing evenly a surface portion of said polyimide resin coating to expose the first-level wiring layer (27a, 27b).

3. A method as claimed in claim 1 or 2, in which the ions are implanted with dosage of more than $1 \times 10^{13}$ cm$^{-2}$.

4. A method as claimed in claims 1, 2 or 3, in which the said ions are impurity ions selected from the group consisting of arsenic ions, phosphorus ions, boron ions and boron difluoride ions.

**Patentansprüche**

1. Verfahren zur Herstellung einer Halbleitervorrichtung mit einer mehrschichtigen Verdrahtungsstruktur, mit den folgenden Schritten:—

Bildung einer Verdrahtungsschicht (27a, 27b) in einem ersten Niveau auf einem Substrat (21, 24),

Bildung einer ersten Polyimidharzschicht (28) auf dem Substrat (21, 24), wobei wenigstens ein Teil der Verdrahtungsschicht (27a, 27b) des ersten Niveau durch die erste Polyimidharzschicht exponiert ist,

Implantieren von Ionen in die erste Polyimidharzschicht (28), um ihre Suszeptibilität gegenüber Ätzen durch ein Ätzmittel, welches Hydrazin enthält, zu verringern,

Bildung einer zweiten Polyimidharzschicht (30) auf der mit Ionen implantierten ersten Polymidharzschicht (28) und der Verdrahtungsschicht (27a, 27b) des ersten Niveaus,

selektives Ätzen der zweiten Polyimidharzschicht (30) unter Verwendung eines Ätzmittels, welches Hydrazin enthält, um in jener Schicht ein Durchgangsloch (33) als ein Verdrahtungsverbindungsfenster zu bilden, in welchem ein Teil der Verdrahtungsschicht (27a, 27b) des ersten Niveaus exponiert ist, und

Bildung einer Verdrahtungsschicht (34) in einem zweiten Niveau, auf der zweiten Polyimidharzschicht (30), die mit der Verdrahtungsschicht (27a, 27b) des ersten Niveaus durch das Verdrahtungsverbindungsfenster (33) verbunden ist,

wodurch dann, falls ein Teil der ersten Polyimidharzschicht (28) in dem Durchgangsloch (33) exponiert ist, sie im wesentlichen ungeätzt bleibt, als Ergebnis ihrer verringerten Suszeptibilität gegenüber Ätzen.

2. Verfahren nach Anspruch 1, bei dem die erste Polymidharzschicht (28) durch ein Verfahren gebildet wird, welches die folgenden Schritte umfaßt: Bildung eines Polyimidharzüberzuges über der Verdrahtungsschicht (27a, 27b) des ersten Niveaus auf dem Substrat (21, 24) und gleichmäßiges Entfernen eines Oberflächenabschnitts des genannten Polyimidharzüberzuges, um die Verdrahtungsschicht (27a, 27b) des ersten Niveaus zu exponieren.

3. Verfahren nach Anspruch 1 oder 2, bei dem die Ionen mit einer Dosierung von mehr als $1 \times 10^{13}$ cm$^{-2}$ implantiert werden.

4. Verfahren nach anspruch 1, 2 oder 3, bei welchem die genannten Ionen Verunreinigungsionen sind, die aus der Gruppe bestehend aus Arsenionen, Phosphorionen, Borionen und Bordifluoridionen ausgewählt sind.

**Revendications**

1. Procédé de fabrication d'un dispositif à semiconducteur ayant une structure de câblage à couches multiples, comprenant les étapes suivantes:

formation d'une couche de câblage de premier niveau (27a, 27b) sur un substrat (21, 24),

formation d'une première couche de résine de polyimide (28) sur le substrat (21, 24) avec au moins une partie de la couche de câblage de premier niveau (27a, 27b) exposée à travers la première couche de résine de polyimide,

implantation d'ions dans la première couche de résine de polyimide (28) pour réduire sensiblement sa sensibilité à la gravure par un agent de gravure contenant de l'hydrazine,

formation d'une seconde couche de résine de polyimide (30) sur la première couche de polyimide à ions implantés (28) et sur la couche de câblage de premier niveau (27a, 27b),

gravure sélective de la seconde couche de résine de polyimide (30) utilisant un agent de gravure contenant de l'hydrazine, pour former un trou traversant (33) dans cette couche en tant que fenêtre de connexion de câblage dans laquelle une partie de la couche de câblage de premier niveau (27a, 27b) est exposée, et

formation sur la seconde couche de résine de polyimide (30) d'une couche de câblage de second niveau (34), connectée à la couche de câblage de premier niveau (27a, 27b) par la fenêtre de connexion de câblage (33),

de sorte que la partie de la première couche de résine de polyimide (28) qui est exposée dans le trou traversant (33) demeure sensiblement non gravée, comme résultat de sa sensibilité réduite à la gravure.

2. Un procédé selon la revendication 1, selon lequel la première couche de résine de polyimide (28) est formée par un procédé qui comprend les étapes suivantes: formation d'un revêtement de résine de polyimide sur la couche de câblage de premier niveau (27a, 27b) sur le substrat (21, 24) et enlèvement d'une manière égale d'une portion de surface dudit revêtement de résine de polyimide pour exposer la couche de câblage de premier niveau (27a, 27b).

3. Un procédé selon la revendication 1 ou 2, selon lequel les ions sont implantés à un dosage supérieur à $1 \times 10^{13}$ cm$^{-2}$.

4. Un procédé selon la revendication 1, 2 ou 3, selon lequel lesdits ions sont des ions d'impuretés choisis dans le groupe comprenant les ions arsenic, les ions phosphore, les ions bore et les ions difluorure de bore.

EP 0 074 845 B1

Fig. 1

Fig. 2A

Fig. 2B

Fig. 2C

Fig. 2D

Fig. 2E

Fig. 2F

Fig. 2G